# EUROPEAN PATENT APPLICATION

(11) **EP 1 130 711 A2**
(43) Date of publication of application: **05.09.2001**
(21) Application number: 00311061.6
(22) Date of filing: 12.12.2000
(51) Int. Cl.: H01S 5/0683, H01S 5/0687, H01S 5/06

(54) **Apparatus and method for separating memory and control functions in a laser control system**

(30) Priority: 11.01.2000 US 480863
(71) Applicant: Agere Systems Optoelectronics Guardian Corporation, Orlando, Florida 32819-8698 (US)
(72) Inventor: Koch, Thomas L., Holmdel, NJ 07733 (US); Mak, Eric S., Center Valley, PA 18034 (US); Ogawa, Kinichiro, Rumson, NJ 07760 (US); Stayt Jr.,John W., Schnecksville, PA 18078 (US)
(74) Representative: Perkins, Sarah

(57) **Abstract**

A method and apparatus are provided for separating the memory and control functions in a wavelength stabilized laser control system. A laser chip and a memory device are provided in a separate package from the laser control system that can be easily removed when the laser chip requires replacement. The memory device stores the necessary operating data for its associated laser chip and provides the control system any necessary calibration and operating data so the control system can easily and quickly update operation for the new laser chip.

## Description

### Field Of The Invention

The present invention relates generally to tunable lasers and other tunable optical signal sources and more particularly to a method and system for separating the memory and control functions in a laser control system.

### Description Of The Related Art

Optical fiber communications systems provide for low loss and very high information carrying capacity. In practice, the bandwidth of optical fiber may be utilized by transmitting many distinct channels simultaneously using different carrier wavelengths. The associated technology is called wavelength division multiplexing (WDM). In a narrow band WDM system, eight, sixteen or more different wavelengths are closely spaced to increase fiber transmission capacity.

To maximize the number of channels, lasers with stable and precise wavelength control are required to provide narrowly spaced, multiple wavelengths. However, in practice, a laser generates light over rather broad bandwidths. The output frequencies are based upon the number of discrete longitudinal modes that are supported by the laser cavity.

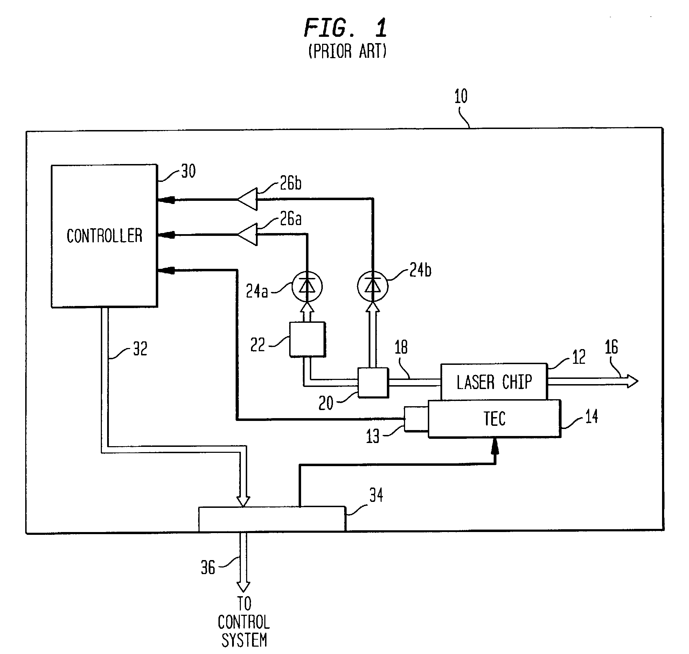

Various approaches have been used to limit the oscillation of a laser to one of the competing longitudinal modes. One of the most common approaches, known as temperature tuning, adjusts the output of the laser by varying the temperature of the laser. Such a method allows for wavelength locking of a laser even in the event of changing ambient temperature conditions. Temperature tuning typically requires the use of a frequency selective external cavity, such as an etalon, to detect the output wavelength at which the laser is operating. Fig. 1 illustrates a portion of a conventional system for laser wavelength stabilization. Specifically, Fig. 1 illustrates a conventional laser module 10 which utilizes an optical filter for wavelength control.

Laser module 10 includes a laser chip 12 mounted on a thermo-electric cooler (TEC) 14. A submount (not shown) between the laser chip 12 and TEC 14 can be used if desired for thermal expansion matching. A thermistor 13 is typically provided to measure the temperature of TEC 14 and laser chip 12. Laser chip 12 generates a laser output 16 and a backface output 18. Backface output 18 is passed through an optical coupler 20 to separate the laser into separate paths, two being illustrated in Fig. 1. A first path is passed through an optical filter, such as an etalon 22, and input to a photodetector 24a to convert the optical signal to an electrical signal. The electrical signal is amplified by amplifier 26a and the resulting signal input to controller 30, which converts the signal from an analog signal to a digital signal for further processing.

A second path is input to a photodetector 24b to convert the optical signal to an electrical signal. The electrical signal is amplified by amplifier 26b and the resulting signal input to controller 30, which converts the signal from an analog signal to a digital signal for further processing. Alternatively, the analog to digital signal conversion can be done by analog to digital (A/D) converters (not shown) placed between the amplifiers 26a, 26b and controller 30.

Controller 30 processes the signals input from each laser path and outputs a control signal on line 32 to connector 34. Controller 30 also outputs operating parameters regarding laser chip 12, such as for example signals representing the laser chip temperature, laser output wavelength, laser output power, etc., on line 32. Optionally, the signals on line 32 may be converted from digital signals to analog signals by a digital to analog (D/A) converter (not shown). Connector 34 passes the signals from line 32 to the remainder of the control system via line 36. Signals based on the control signal from controller 30 are passed from the control system through connector 34 to TEC 14, which in response varies the temperature of laser chip 12, thereby adjusting the wavelength of laser output 16, 18.

There are problems, however, with the conventional laser module 10. Currently, the memory and control functions for the laser chip are performed by the control system. Thus, if the laser chip 12 requires replacements, the entire laser module must be replaced and the control system re-calibrated for the new laser chip, as laser chips can vary somewhat from chip to chip. Even lasers designed to operate at similar wavelengths can vary slightly due to the tolerances of the laser chip. Additionally, as laser chips age, their performance can vary. Each time a new laser chip is installed into a laser control system, information concerning the starting conditions of the laser chip, determined during manufacturing testing and calibration of the laser chip, must be entered into the control system and the control system re-calibrated to adjust for any variance of the new laser chip. For example, information such as the laser bias current, wavelength look-up tables (to determine the necessary temperature of the laser chip to output a desired wavelength), etc. must be provided for the control system.

Replacement of the complete laser module and re-calibration of the control system for the new laser chip increases both the time required for replacement and cost. Thus, there exists a need for a wavelength stabilized laser system that allows for economical and easy replacement of a laser chip.

### Summary Of The Invention

The present invention alleviates the problems associated with the prior art by providing a unique method and apparatus for separating the memory and control functions in a wavelength stabilized laser system, allowing for economical and efficient replacement of the laser chip.

In accordance with the present invention, a laser chip and a memory device are provided in a separate package from the laser control system that can be easily removed when the laser chip requires replacement. The memory device stores the necessary operating data for its associated laser chip and provides the control system any necessary calibration and operating data so the control system can easily and quickly update operation for the new laser chip. This apparatus and method provides a low cost and efficient solution, since replacement of the laser chip no longer requires replacement of the entire laser module, i.e., fewer components need to be replaced, and the control system is re-calibrated from the information stored in the memory device.

These and other advantages and features of the invention will become apparent from the following detailed description of the invention which is provided in connection with the accompanying drawings.

### Brief Description Of The Drawings

FIGURE 1 illustrates in block diagram form a portion of a conventional system for laser wavelength stabilization;
FIGURE 2 illustrates in block diagram form a portion of a wavelength stabilized laser control system having separate memory and control functions in accordance with the present invention; and
FIGURE 3 illustrates in block diagram form a storage device that can be used in the laser/memory module of Fig. 2.

### Detailed Description

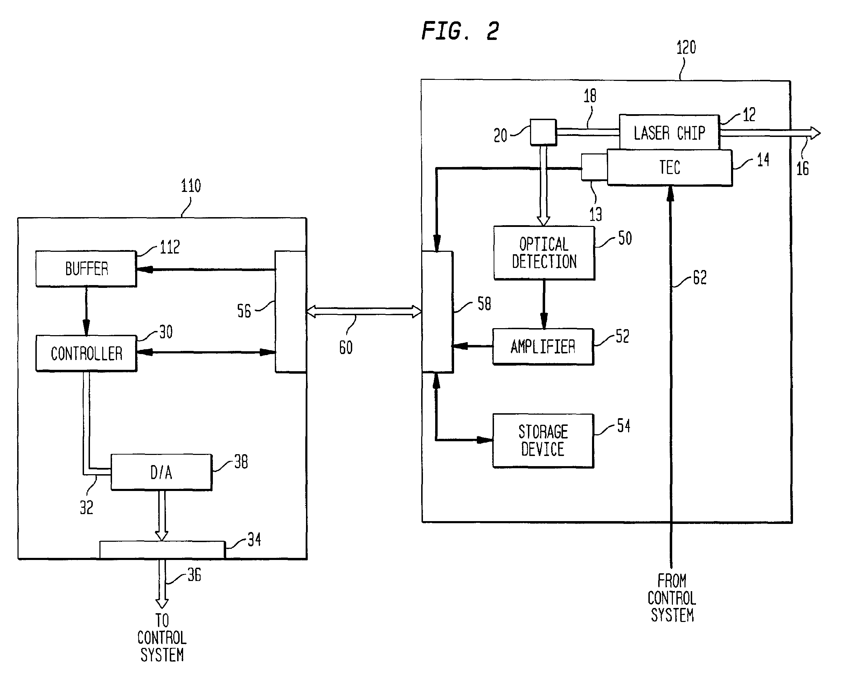

The present invention will be described as set forth in the embodiment illustrated in Figs. 2-3. Other embodiments may be utilized and structural, logical or programming changes may be made without departing from the spirit or scope of the present invention. Like items are referred to by like reference numerals throughout the description.

In accordance with the present invention, the memory and control functions in a wavelength stabilized laser system are separated by providing a laser chip and a memory device in a package separate from the control functions of the laser control system, allowing for economical and efficient replacement of the laser chip.

Fig. 2 illustrates in block diagram form a portion of a wavelength stabilized laser control system having separate memory and control functions in accordance with the present invention. Specifically, Fig. 2 illustrates a general electronics control module 110 and a laser/memory module 120. In accordance with the present invention, the laser/memory module 120 is separate from and removable from the remainder of the laser control system, including control module 110.

Laser/memory module 120 includes a laser chip 12 mounted on a thermo-electric cooler (TEC) 14. A submount (not shown) between the laser chip 12 and TEC 14 can be used if desired for thermal expansion matching. A thermistor 13 is typically provided to measure the temperature of TEC 14 and laser chip 12. Laser chip 12 generates a laser output 16 and a backface output 18. Backface output 20 is passed through an optical coupler 20 to separate the laser into separate paths. Each of the laser paths are passed through an optical detection unit 50, which may include for example an optical filter, such as an etalon, in one of the paths, and photodetectors in each path for converting the optical signals of each laser path into electrical signals. The electrical signals representing each laser path from the optical detection unit 50 are amplified by amplifier 52 and output via connector 58 from laser/memory module 120.

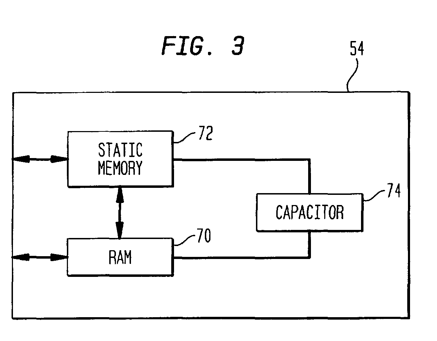

In accordance with the present invention, laser/memory module 120 includes a storage device 54 for storing information with respect to the start-up and operation of laser chip 12. Storage device 54 can be any type of memory or memory system capable of retaining data in the absence of power, such as for example an electrically erasable programmable read only memory (EEPROM), flash memory, etc. The storage device 54 can also be a system comprising random access memory (RAM) 70, static memory 72 and a capacitor 74 as illustrated in Fig. 3, where data is maintained in the random access memory 70 and upon a power failure the data is written into the static memory 72 with the reserve power held in the capacitor 74. The stored information includes information critical to the proper operation of the laser chip 12 such as, for example, laser bias current, look-up tables, etc., that are determined during manufacturing performance and reliability testing of laser chip 12.

Referring back to Fig. 2, control module 110 includes a connector 56 that mates with connector 58 of laser/memory module 120 and allows for transmission of signals between laser/memory module 120 and control module 110, illustrated by arrow 60. Control module further includes a buffer circuit 112 which receives the signals representing the laser paths from amplifier 52 of laser/memory module 120 via line 56 and also receive signals from thermistor 13. After the signals from laser/memory module 120 are passed through buffer 112, they are input to a controller 30, which converts the signal from an analog signal to a digital signal for further processing. Controller 30 may include a microcontroller or programmable logic device, one example being a microprocessor. If a microprocessor is used, it may be any conventional general purpose single- or multi-chip microprocessor, or may be any conventional special purpose microprocessor such as a digital signal processor. Alternatively, the analog to digital signal conversion can be done by an analog to digital (A/D) converter (not shown) located between the buffer 112 and controller 30. Storage device 54 of laser/memory module 120 is also connected to controller 30 through connectors 56, 58.

Controller 30 processes the signals representing each laser path and the temperature of the TEC 14 as measured by thermistor 13 input from buffer 112 and outputs a control signal on line 32 to connector 34. Controller 30 also outputs operating parameters regarding laser chip 12, such as for example signals representing the laser chip temperature, laser output wavelength, laser output power, etc., on line 32. Optionally, the signals on line 32 may be converted from digital signals to analog signals by a digital to analog (D/A) converter 38. Connector 34 passes the signals from line 32 to the remainder of the control system via line 36. Signals from the control system are sent to TEC 14 on line 62 based on the control signal from controller 30, which in response varies the temperature of laser chip 12, thereby adjusting the wavelength of laser output 16, 18. Controller 30 can also output information regarding the current operating conditions of laser chip 12 to storage device 54 of laser/memory module 120 via connectors 56, 58 for updating the operating conditions stored in storage device 54 to account for aging of the laser chip 12.

In accordance with the present invention, laser/memory module 120 can be easily replaced in the laser control system without having to remove the control module 110 by disconnecting the connectors 56, 58. Furthermore, replacement of the laser/memory module 120 will not require significant re-testing and re-calibration of the laser system, as firmware within controller 30 is used to extract the data stored in storage device 54 of the new laser/memory module 120 through connectors 56, 58 concerning the start-up and operating conditions of the new laser chip 12 when a new laser/memory module 120 is inserted into the laser system.

Thus, by separating the memory and control functions in a wavelength stabilized laser system, only a small portion of the laser system needs to be replaced when replacing the laser chip. The ability to replace only a small portion of the laser system, i.e., only the laser/memory module 120, and the use of the storage device 54 to store data concerning the laser chip 12 results in an economical and efficient solution to replacing a laser chip in a laser system.

While the invention has been described as being implemented with a laser chip 12, it is to be understood that the invention is not so limited and may be used with any type of laser source as is known in the art, such as for example an array of lasers, a DFB laser, a distributed Bragg reflector (DBR) laser, a Fabry-Perot laser, etc. Additionally,' while the invention has been described with respect to a laser control system which utilizes an optical filter, such as an etalon, the invention is not so limited and may be used with any type of laser control system as is known in the art.

Reference has been made to embodiments in describing the invention. However, additions, deletions, substitutions, or other modifications which would fall within the scope of the invention defined in the claims may be implemented by those skilled in the art and familiar with the disclosure of the invention without departing from the spirit or scope of the invention. Accordingly, the invention is not to be considered as limited by the foregoing description, but is only limited by the scope of the appended claims.

## Claims

1. A laser module comprising:
a laser source for producing a laser output; and
a storage device for storing operating parameters of said laser source;
wherein said laser module is removable from a laser control circuit for controlling operation of said laser source in a laser system.

2. The laser module according to claim 1, further comprising:
a connector for connecting said laser module to said laser control circuit of said laser system.

3. The laser module according to claim 1, further comprising:
a temperature device for controlling a temperature of said laser source.

4. The laser module according to claim 3, wherein said temperature device is a thermo-electric cooler (TEC).

5. The laser module according to claim 1, further comprising:
an optical detection unit to detect said laser output and convert said laser output into an electrical signal; and
an amplifier circuit to amplify said electrical signal.

6. The laser module according to claim 1, wherein said storage device includes a memory.

7. The laser module according to claim 6, wherein said memory is an electrically erasable programmable read only memory (EEPROM).

8. The laser module according to claim 1, wherein said storage device includes a capacitor.

9. The laser module according to claim 8, wherein said storage device further includes static memory.

10. The laser module according to claim 9, wherein said storage device further includes random access memory.

11. The laser module according to claim 1, wherein said operating parameters are determined during performance testing of said laser source.

12. The laser module according to claim 11, wherein said operating parameters include start-up conditions for said laser source.

13. A laser system comprising:
a control module; and
a removable laser module connected to said control module, said laser module comprising a laser source for producing a laser output and a storage device for storing operating parameters of said laser source,
wherein said control module is adapted to receive signals representing said laser output and said operating parameters stored in said storage device of said laser source and operate said laser system based on said signals.

14. The laser system according to claim 13, wherein said laser module further comprises:
a temperature device for controlling a temperature of said laser source.

15. The laser system according to claim 14, wherein said temperature device is a thermo-electric cooler (TEC).

16. The laser system according to claim 14, wherein said laser module further comprises:
an optical detection unit to detect said laser output and convert said laser output into an electrical signal; and:
an amplifier circuit to amplify said electrical signal.

17. The laser system according to claim 13, wherein said storage device includes a memory.

18. The laser system according to claim 17, wherein said memory is an electrically erasable programmable read only memory (EEPROM).

19. The laser system according to claim 13, wherein said storage device includes a capacitor.

20. The laser system according to claim 19, wherein said storage device further includes static memory.

21. The laser system according to claim 20, wherein said storage device further includes random access memory.

22. The laser system according to claim 13, wherein said operating parameters are determined during performance testing of said laser source.

23. The laser system according to claim 22, wherein said operating parameters include start-up conditions for said laser source.

24. The laser system according to claim 13, wherein said control module is further adapted to update said operating parameters stored in said storage device.

25. The laser system according to claim 13, wherein said control module includes a controller.

26. The laser system according to claim 25, wherein said controller includes a processor.

27. The laser system according to claim 26, wherein said processor includes a microprocessor.

28. The laser system according to claim 25, wherein said control module further comprises:
a buffer circuit connected to said controller, said buffer circuit adapted to receive said signals representing said laser output and said operating parameters stored in said storage device and output said signals to said controller.

29. A method for operating a replaceable laser source in a laser system, said method comprising the steps of:
storing a plurality of operating parameters of said replaceable laser source in a storage device packaged with said replaceable laser source;
connecting said replaceable laser source and storage device to a control portion of said laser system;
inputting said plurality of stored operating parameters from said storage device to said control portion; and
controlling operation of said replaceable laser source in said laser system with said control portion based on said plurality of operating parameters input to said control portion.

30. The method according to claim 29, wherein before said step of storing, said method further comprises:
determining said plurality of operating parameters during testing of said replaceable laser source.

31. The method according to claim 29, further comprising:
updating at least one of said plurality of operation parameters during operation of said replaceable laser source in said laser system.

32. The method according to claim 29, wherein said step of storing includes:
storing a plurality of operating parameters of said replaceable laser source in a memory device packaged with said replaceable laser source.

33. The method according to claim 32, wherein said memory device is an electrically erasable programmable read only memory (EEPROM).

34. The method according to claim 29, wherein said step of inputting said plurality of stored operating parameters to said control portion further comprises:
providing a plurality of signals, each of said plurality of signals representing a respective one of said plurality of operating parameters;
buffering said plurality of signals; and
inputting said plurality of signals to said control portion.
